(19) **Europäisches Patentamt**
**European Patent Office**
**Office européen des brevets**

(11) **EP 2 073 280 A1**

(12) **EUROPÄISCHE PATENTANMELDUNG**

(43) Veröffentlichungstag:
**24.06.2009 Patentblatt 2009/26**

(51) Int Cl.:
*H01L 31/052* (2006.01)    *H01L 33/00* (2006.01)
*H01L 25/04* (2006.01)

(21) Anmeldenummer: **07024799.4**

(22) Anmeldetag: **20.12.2007**

(84) Benannte Vertragsstaaten:
**AT BE BG CH CY CZ DE DK EE ES FI FR GB GR
HU IE IS IT LI LT LU LV MC MT NL PL PT RO SE
SI SK TR**
Benannte Erstreckungsstaaten:
**AL BA HR MK RS**

(71) Anmelder: **Fraunhofer-Gesellschaft zur
Förderung der angewandten Forschung e.V.
80686 München (DE)**

(72) Erfinder:
• **Jaus, Joachim, Dipl.-Wi.-Ing.
79098 Freiburg (DE)**

• **Bett, Andreas, Dr.
79114 Freiburg (DE)**
• **Passig, Michael
06420 Golbitz (DE)**
• **Peharz, Gerhard
79102 Freiburg (DE)**
• **Nitz, Peter, Dr.
79194 Gundelfingen (DE)**
• **Graf, Wolfgang, Dipl.-Ing.
79427 Eschbach (DE)**

(74) Vertreter: **Pfenning, Meinig & Partner GbR
Patent- und Rechtsanwälte
Theresienhöhe 13
80339 München (DE)**

(54) **Reflektive Sekundäroptik und Halbleiterbaugruppe sowie Verfahren zu dessen Herstellung**

(57) Vorliegende Erfindung betrifft eine reflektive und/oder refraktive Sekundäroptik zur Fokussierung von Sonnenlicht auf Halbleiterbauelemente, wobei die Sekundäroptik erfindungsgemäß durch eine Auskragung gekennzeichnet ist, die um den die Sekundäroptik bildenden Grundkörper herum angeordnet ist. Weiterhin betrifft vorliegende Erfindung eine Halbleiterbaugruppe, die die erfindungsgemäße Sekundäroptik umfasst, sowie ein Verfahren zur Herstellung dieser Halbleiterbaugruppe. Insbesondere stellt diese Halbleiterbaugruppe ein konzentrierendes Solarzellenmodul dar.

Fig.2a

EP 2 073 280 A1

**(Forts. nächste Seite)**

Fig.2b

Fig.2c

**Beschreibung**

Vorliegende Erfindung betrifft eine reflektive und/oder refraktive Sekundäroptik zur Fokussierung von Sonnenlicht auf Halbleiterbauelemente, wobei die Sekundäroptik erfindungsgemäß durch eine Auskragung gekennzeichnet ist, die um den die Sekundäroptik bildenden Grundkörper herum angeordnet ist. Weiterhin betrifft vorliegende Erfindung eine Halbleiterbaugruppe, die die erfindungsgemäße Sekundäroptik umfasst, sowie ein Verfahren zur Herstellung dieser Halbleiterbaugruppe. Insbesondere stellt diese Halbleiterbaugruppe ein konzentrierendes Solarzellenmodul dar.

In der Konzentrator-Photovoltaik wird Licht mittels eines optischen Systems auf Solarzellen konzentriert. Hierzu wird z.B. eine Linse oder ein Fresnel-Kollektor verwendet, die das einfallende Licht auf die Solarzelle bündeln. Mehrere Solarzellen werden mit dem dazugehörigen optischen System, z.B. einem Linsenarray, sowie Bauelementen zur Kühlung und zur elektrischen Verschaltung zu Modulen zusammengebaut. Diese Module werden auf sog. Tracker montiert, auf denen sie dem Lauf der Sonne nachgeführt werden.

In der Konzentrator-Photovoltaik ist es von großem Interesse, dass möglichst viel des eingestrahlten Lichtes auf die Solarzelle trifft. Dies wird zum einen durch die Abbildungsqualität des optischen Systems beeinflusst, zum anderen durch die Genauigkeit, mit der das optische System zur Zelle sowie das Modul insgesamt zur Sonne ausgerichtet ist.

Ein weiterer wichtiger Gesichtspunkt in der Konzentrator-Photovoltaik ist der sog. Konzentrationsfaktor. Dieser gibt das Verhältnis der Lichteintrittsfläche der Optik zur aktiven Fläche der Solarzelle an. Um möglichst wenig der relativ teuren Solarzellenfläche einzusetzen, wird der Konzentrationsfaktor so groß wie möglich gewählt. Gerade bei hochkonzentrierenden Systemen bietet sich der Einsatz einer zweistufigen Optik an, deren beiden Elemente dann als Primäroptik (erstes optisches Element im Strahlengang, z.B. die Linse oder der Fresnel-Kollektor) bzw. Sekundäroptik (zweites Element) bezeichnet werden. Ein zweistufiges Konzept hat den Vorteil, dass die Strahlablenkung bei jedem einzelnen Element geringer ausfallen kann. Außerdem vergrößert sich der Gestaltungsspielraum beim Optik-Design deutlich, z.B. zur Verringerung der chromatischen Aberration oder zur Homogenisierung der Einstrahlung.

Die Sekundäroptik wird bisher meistens als refraktives Bauelement ausgeführt, bei dem die Lichtstrahlen durch interne Totalreflektion auf die Solarzelle gelenkt werden. Bekannt sind hier Elemente aus Glas in der Form eines Pyramidenstumpfes (US 5,505,789) oder aufwändigere Formen, die hauptsächlich auf Totalreflektion beruhen und im Spritzgussverfahren hergestellt werden (z.B. ES 2232299; V. Diaz, J. Alarez, J. Alonso et al., "Assembly of Concentrator Modules based on Silicon Solar Cells at 300x of Concentrated Sunlight", Proc. of 19th European Photovoltaic Solar Energy Conference, 2004).

Um möglichst wenig Reflektion an der Austrittsfläche, verursacht durch große Unterschiede im Brechungsindex, zu erzielen, ist dieses Bauelement normalerweise über ein adhäsives und optisch transparentes Material, z.B. Silikon, direkt auf die Solarzelle montiert und an der Eintrittsapertur evtl. mit einer reflektionsmindernden Beschichtung versehen.

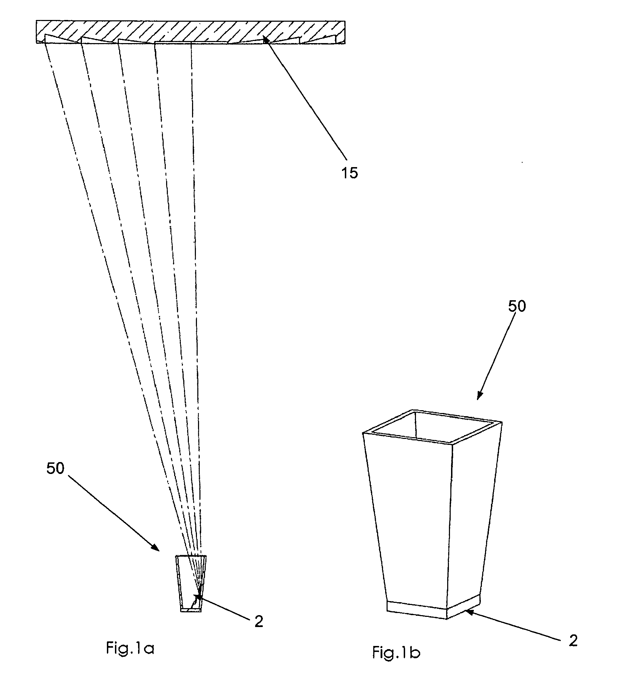

Gleichzeitig kommen auch einfache Sekundäroptiken zum Einsatz, die auf Reflektion an spiegelnden Oberflächen beruhen. In den bisher bekannten Anwendungen kommen hierzu trapezförmige metallene Körper oder runde Trichter zum Einsatz (siehe z.B. EP 0 657 948 A2; WO 91/18419; L. M. Fraas, "Line-Fokus Photovoltaic Module Using Stacked Tandem-Cells", 1994). Um die Reflektion dieser Bauteile zu erhöhen, werden die Bleche häufig vor der Umformung mit hoch reflektiven Schichten versehen. Derartige Aufbauten sind z.B. aus US 5,167,724 oder US 5,505,789 bekannt und illustrativ in Fig. 1 wiedergegeben. Dabei ist die Sekundäroptik 50 direkt auf der Solarzelle 2 angebracht. Das Sonnenlicht wird durch den Fresnel-Kollektor 15 auf die Sekundäroptik so vorfokussiert.

Weiterhin sind nach dem Stand der Technik Bauteile bekannt (WO 2004/077558 A1; DE 195 36 454 A1; DE 199 47 044 B4), die darauf ausgelegt sind, in Verbindung mit Halbleiterbauelementen eingesetzt zu werden, bei denen die Strahlung ganz oder teilweise an den Seitenflächen austritt oder empfangen wird. Diese seitliche Abstrahlung ist für LED-Halbleiterchips charakteristisch. Werden jedoch Halbleiterbauelemente verwendet, die fast ausschließlich mehr als 95 % der Strahlung zur Oberseite des Halbleiterchips aussenden oder empfangen, wie z.B. Solarzellen, so geht mit dem Reflektorkonzept nach diesen Patenten ein Teil der Strahlung verloren, da die Reflektoren darauf ausgelegt sind, dass der Halbleiterchip von oben in die Reflektorausformung hineingesetzt wird und damit sowohl Seitenwände als auch obere Kontaktierungsfläche im Strahlenlauf des Reflektors liegen. Bei dieser Bauform schließen die reflektierenden Bereiche den gesamten Halbleiterchip ein.

Aus DE 199 47 044 B4 ist z.B. ein Bauelement bekannt, bei dem der Sender und/oder Empfänger von einem metallischen Reflektor umgeben ist. Auch die aus dieser Druckschrift bekannte integrale Ausformung der Reflektorwände aus dem Leiterbandmaterial beruht auf dem Prinzip, dass der Chip in den Reflektor hineingesetzt werden kann, der Chip also kleiner ist als der kleinste Reflektordurchmesser/Reflektorquerschnitt.

Aus DE 195 36 454 A1 ist ebenfalls eine wannenförmige Ausbildung eines Reflektors bekannt, in die der Halbleiterchip hineingesetzt wird.

Aus WO 2004/077558 A1 ist ein Bauelement bekannt, bei dem durch Metallisierung eines Gehäusekörpers ein Reflektor realisiert wird. Auch hier ist der Halbleiterchip auf einen ersten Bereich der Metallisierung aufgebracht. Soll nur ein Teil der Chipfläche in der Austrittsapertur des Reflektors liegen, ist diese Bauform nicht geeignet.

Dieser Stand der Technik weist in Hinsicht auf die refraktiven Sekundäroptiken folgende Nachteile auf:

- Durch Absorption im Material der Sekundäroptik wird ein Teil des Lichtes absorbiert und steht damit nicht mehr für die Umwandlung in der Solarzelle zur Verfügung.
- Durch die Absorption des Lichts im Material heizt sich das Material stark auf, so dass es insbesondere bei hochkonzentrierenden Systemen zu einer Zerstörung der Sekundäroptik kommen kann.
- An der Eintrittsfläche der refraktiven Optik kommt es durch den großen Brechungsunterschied gegenüber der Umgebungsluft zu Reflektionen. Diese können zwar durch Antireflexschichten gemindert werden, diese erhöhen jedoch die Fertigungskosten und können Reflektionen nur verringern, nicht aber verhindern.
- Das Prinzip der Totalreflektion (total internal reflection, TIR) stellt sehr hohe Anforderungen an die Oberflächenqualität der Bauteile. Dies wirkt sich als starker Kostentreiber in der Produktion aus, da die bei hohen Stückzahlen favorisierten Fertigungsverfahren, wie Umformen oder Spritzgießen und die damit erreichbaren Oberflächenqualitäten häufig nicht ausreichen. Durch Schleifen lassen sich die Oberflächenqualitäten erzielen, dies ist in der hochvolumigen Fertigung jedoch ein relativ teurer Prozess, der sich nicht mit den zulässigen Kosten in der Konzentrator-Photovoltaik verträgt.
- Zur Vermeidung von Reflektionen ist der Raum zwischen Zelle und Sekundäroptik wie beschrieben mit einem optischen Medium ausgefüllt (siehe z.B. ES 2232299, US 5,505,789). Zur Minimierung von Lufteinschlüssen wird dieses Medium normalerweise in viskosem Zustand aufgetragen und nach Montage der Sekundäroptik ausgehärtet. Durch Kapillareffekte oder Benetzungseffekte kommt es jedoch häufig zur Benetzung der Außenwand der Sekundäroptik mit dem flüssigen Medium, wodurch der Wirkungsgrad der TIR herabgesetzt wird. Aufgrund der Oberflächenspannung des optischen Mediums kommt es im Bereich der Kanten der Sekundäroptik zur Bildung von charakteristischen Fugen, die ebenfalls zur Auskopplung von Licht und damit zur Verringerung des Wirkungsgrades führen.
- Da die Sekundäroptik prinzipbedingt die ganze Solarzellenfläche abdecken muss, müssen auch alle Strahlen, die auf die Solarzelle gelenkt werden sollen, vorher die Sekundäroptik durchlaufen. Dies führt jedoch bei den Strahlen, die auch ohne diese Optik auf die Zelle treffen würden, zu unnötigen Verlusten. Gerade bei sehr guten Primäroptiken trifft ein Großteil der Strahlen auch ohne Sekundäroptik auf die Zelle. Optimal ist in diesem Fall also eine Sekundäroptik, die ergänzend zur Primäroptik arbeitet und nur den Teil der Strahlen erfasst, der ohne weiteres Eingreifen nicht auf die Zelle treffen würde.

In Hinsicht auf die bisherigen Ausführungen von reflektiven Sekundäroptiken sind folgende Nachteile zu nennen:

- Die bekannten Sekundäroptiken sind schwierig zu Montieren, da es keine Elemente gibt, die das automatische Greifen erleichtern oder die Montage auf der Zelle vereinfachen.
- Die aus WO 91/18419, ES 2232299 oder WO 2006/130520 A2 bekannten Montageverfahren beruhen auf der Verwendung zahlreicher zusätzlicher Montage-Hilfsmittel, wie z.B. Schrauben, Rahmen oder Klemmbügel. Dies treibt die Material- und Prozesskosten in die Höhe und erhöht die Zahl der fehleranfälligen Komponenten und damit die Ausfallwahrscheinlichkeit des Gesamtsystems.
- In Bezug auf die Reflektoren für Halbleiterchips aus (WO 2004/077558 A1; DE 195 36 454 A1; DE 199 47 044 B4) ist der Hauptnachteil, dass die dort beschriebenen Bauteile dafür ausgelegt sind, dass der Halbleiterchip in eine reflektierende Ausformung gesetzt wird. Dadurch ist aber nur ein relativ undefinierter Strahlenverlauf realisierbar, je nach Ein-/Ausstrahlwinkel liegen auch die Seitenwände oder die Oberflächenmetallisierung im Strahlenverlauf.
- Da die Reflektionsschichten auf den Blechen im Umformprozess bei zu starker Umformung reißen, ist man in der Realisierungsmöglichkeit besonderer Geometrien stark eingeschränkt.
- Durch Absorption im Material können sich die Sekundäroptiken stark erhitzen. Bisher ist der Einsatz von speziellen Elementen zur Erhöhung der Wärmeabfuhr nur in einer Anmeldung dokumentiert (WO 91/18419), bei der die Wärmeabfuhr aber über eine aufwändig herzustellende zusätzliche Komponente realisiert wird.
- Die Spiegelschichten (z.B. Silber-basierte Schichtsysteme) weisen eine hohe Korrosionsanfälligkeit auf. Um dies zu verhindern, werden die reflektierenden Bleche mit einer Passivierungsschicht versehen. Da die Bauteile jedoch aus fertig beschichteten Blechbändern zugeschnitten werden, weisen die Schnittränder offen liegende Materialübergänge auf, an denen die Spiegelschichen nicht passiviert sind. Diese Schnittränder bilden im Betrieb Keimzellen für Korrosion.
- Weitere Nachteile sind bei den entsprechenden Patentzitaten in der Dokumentation zum Stand der Technik zu finden.

Der Erfindung liegt die Aufgabe zugrunde, ein optoelektronisches Bauteil, speziell ein Strahlung aussendendes oder empfangendes Halbleiterbauelement, derart weiterzubilden, dass die auszusendende oder zu empfangende Strahlung auf den Halbleiterchip gelenkt sowie die entstehende Wärme abgeführt wird. Die Erfindung bezieht sich dabei auf Aufgabenstellungen, bei denen Halbleiterchips eingesetzt werden, die Ihre Strahlung ausschließlich oder zu mehr als 90 % über die in Waferebene gelegenen Fläche aufnehmen/aussenden.

Es ist daher Aufgabe der vorliegenden Erfindung, eine reflektive und/oder refraktive Sekundäroptik bereitzustellen, die die im Voranstehenden genannten Nachteile überwindet. Ebenso ist es Aufgabe der Erfindung, eine Halbleiterbaugruppe bereitzustellen, die diese Sekundäroptik enthält.

Diese Aufgabe wird bezüglich der Sekundäroptik mit den Merkmalen des Anspruchs 1 und bezüglich der Halbleiterbaugruppe mit den Merkmalen des Anspruchs 23 gelöst. Mit Anspruch 38 wird ein Verfahren zur Herstellung der zuvor genannten Halbleiterbaugruppe angegeben. Die jeweiligen abhängigen Ansprüche stellen dabei vorteilhafte Weiterbildungen dar. Der Wortlaut der Ansprüche wird durch Inbezugnahme in die Beschreibung mit aufgenommen.

Spezielle Anwendungsfälle sind die Anwendung in einem Modul zur Stromerzeugung aus Sonnenlicht, bevorzugt einem Modul mit einer zweistufigen Konzentrator-Optik, besonders bevorzugt einem Modul mit einer monolithischen Mehrfachsolarzelle, z.B. einer Dreifachsolarzelle, bevorzugt mit einer Solarzelle aus den Elementen der III, und V. Hauptgruppe des Periodensystems.

Die Funktion der erfindungsgemäßen Sekundäroptik ist es, die an der Eingangsapertur eintreffenden Strahlung auf die an der Ausgangsapertur liegende Solarzelle zu lenken. Zur Erzielung dieser Funktionalität sollte die Sekundäroptik bevorzugt folgende Merkmale und Elemente aufweisen:

- Geeignete Formgebung und Oberflächenausführung zur Maximierung des Wirkungsgrades,
- Elemente zur Erleichterung der Montage in der Serienproduktion,
- Elemente zum Wärmemanagement, d.h. zur Verbesserung der Konvektion und der Wärmestrahlung,
- Elemente, die die Langzeitstabilität erhöhen,
- Elemente, die den Reflektionsgrad erhöhen,
- Elemente, um kritische Bereiche neben der Solarzelle abzuschatten.

An den Herstellungsprozess zur Fertigung dieses Bauteils bestehen folgende Anforderungen:

- Geringe Material- und Prozesskosten,
- Hohe Fertigungsgenauigkeit in Bezug auf Reflektorform,
- Erzeugung von Oberflächen mit geringer Rauheit,
- Minimierung von Grat- und Riefenbildung,
- Aufbringung von möglichst homogenen Schichten zur Reflektionssteigerung mit guten optischen Eigenschaften und hoher Haftkraft,
- Aufbringung von möglichst dichten Schutzschichten mit hoher Transparenz und guter Haftung. Der Erfindungsgegenstand betrifft dabei nicht nur das eigentliche Reflektorbauteil (Sekundäroptik), sondern das gesamte Halbleiterbauteil oder -baugruppe, das die Sekundäroptik umfasst. Insbesondere ist das Halbleiterbauteil dabei eine sog. Solarzellenbaugruppe, meist SCA genannt (engl. Solar Cell Assembly). Dieses SCA umfasst typischerweise die Solarzelle, den Reflektor, weitere Elemente sowie den Prozess zur Herstellung eines derartigen SCA.

Eine typische Solarzellenbaugruppe nach dem Stand der Technik (z.B. US 5,167,724; J. Jaus, U. Fleischfresser, G. Peharz et al., "Heat Sink Substrates for Automated Assembly of Concentrator Modules", Proc. of 21st European Photovoltaic Solar Energy Conference, 2006, pp. 2120-2123; A. W. Bett, C. Baur, F. Dimroth et al., "FLATCON™-modules: Technology and Characterisation", Proc. of 3rd World Conference on Photovoltaic Energy Conversion, 2003, pp. 634-637) besteht aus der Solarzelle, einem Substrat zur Wärmeleitung, z.B. Kupfer, mehreren aufgebrachten Metallschichten zur Verbesserung der Kontaktierbarkeit, einer Lot- oder Kleberschicht zur Kontaktierung der Solarzellenrückseite sowie gebondeten oder geschweißten Kontaktierungen der Solarzellenoberseite. Im Folgenden wird das Substrat zur Wärmeleitung auch häufig als "Chipträger" bezeichnet. Häufig ist dieser Chipträger als Leadframe (Leiterrahmen) ausgeführt.

Durch den Einsatz einer erfindungsgemäßen reflektiven und/oder refraktiven Sekundäroptik wird eine Halbleiterbaugruppe, insbesondere ein Solarzellenmodul vom Bautyp nach A. W. Bett, C. Baur, F. Dimroth et al., "FLATCON™-modules: Technology and Characterisation", Proc. of 3rd World Conference on Photovoltaic Energy Conversion, 2003, pp. 634-637, wesentlich verbessert. Eine derartige Solarzellenbaugruppe mit integrierter Sekundäroptik weist dabei die folgenden Vorteile gegenüber dem Stand der Technik auf:

- Gute Ableitung der von der Solarzelle ausgehenden Wärme,
- Schutz der kritischen Bereiche der Solarzelle (z.B. Ränder der aktiven Schichten, Bondpads) vor Korrosion, thermischer Belastung und/oder Schädigung durch Lichteinstrahlung,
- Resistenz aller verwendeten Elemente gegen die Solarstrahlung, die durch die Fokussierung eine bis zu 10.000-fache Konzentration erreicht.
- Langzeitbeständigkeit des gesamten Aufbaus,
- Verwendungsmöglichkeit kostengünstiger Ausgangsmaterialien,
- Vermeidung und/oder Ausgleich der im Betrieb entstehenden thermischen und/oder mechanischen Spannungen.

Das erfindungsgemäße Verfahren zur Herstellung eines Halbleiterbauteils, insbesondere einer Solarzellenbaugruppe mit reflektiver Sekundäroptik, weist die folgenden Vorteile auf:

- Geringe Material- und Prozesskosten,
- Hohe Positionierungsgenauigkeit der Sekundäroptik relativ zur Solarzelle,
- Vermeidung von Beschädigungen von Solarzelle, Sekundäroptik oder anderen auf der Solarzellenbaugruppe vorhandenen Elementen im Bestückungsvorgang.
- Ausgleich von unvermeidbaren Qualitätsmängeln der verwendeten Bauteile (z.B. Grate an der Reflektorunterseite), dadurch Erhöhung der Gesamtausbeute im Fertigungsprozess. Der Erfindungsgegenstand besteht in einer reflektiven und/oder refraktiven Sekundäroptik sowie in einer Solarzellenbaugruppe mit integrierter reflektiver Sekundäroptik, die durch ihr besonderes Design und ihre speziellen Herstellungsprozesse große Vorteile gegenüber aus dem Stand der Technik bekannten Anordnungen aufweisen.

Zur Montage wird ein zweistufiges Verfahren vorgeschlagen, bei dem die eigentliche Verbindung den Reflektor mechanisch nicht kraftschlüssig an die Zelle, sondern direkt an den Chipträger ankoppelt. Außerdem wird eine Montagemethode vorgeschlagen, bei der ein Sekundärreflektor erfindungsgemäß in eine Ausformung einer zuvor aufgebrachten Umhüllung eingebracht wird.

Die erzeugten Verbesserungen werden im Folgenden im Sinne von vorteilhaften Ausgestaltungen dargestellt, die allesamt fakultativ zu verstehen sind.

Vorteilhafte Ausgestaltungen:

Betreffend die Sekundäroptik:

● Der Reflektor besteht aus Aluminium oder einer Aluminiumlegierung. Besonders geeignet sind hochreines Aluminium (> 99 % Aluminium) sowie Aluminiumlegierungen mit > 99 % Aluminium und Beimengungen < 0.5 % von Magnesium. Weitere vorteilhafte Ausgangsmaterialien sind Edelstahl und Messing.

● Die Reflektoraußenseite ist mit einer Schicht versehen, die ein hohes Abstrahlungsvermögen für Infrarotstrahlung mit Wellenlänge > 4000 nm besitzt.

● Bei Reflektoren aus Aluminium oder einer Aluminiumlegierung besteht diese Schicht vorteilhafterweise aus einer gezielt aufgebrachten Aluminiumoxid-Schicht. Durch diese Schicht kann die Temperatur des Reflektors gesenkt werden, mit allen damit verbunden Vorteilen.

● Die Innenseite des Reflektors ist mit einer hochreflektierenden Silber enthaltenden Schicht sowie mit Schutzschichten versehen, die diese hochreflektive Schicht schützen. Vorteilhaft werden Aluminiumoxid oder Siliziumoxid verwendet.

● Die Innenseite des Reflektors ist mit einer hoch reflektierenden Reinst-Aluminium (> 99 %) enthaltenden Schicht sowie mit Schutzschichten versehen, die diese hochreflektive Schicht schützen. Vorteilhaft werden Aluminiumoxid oder Siliziumoxid verwendet.

Betreffend den Ring des Reflektors (Auskragung):

● Die Baugruppe, bestehend aus Solarzelle, Wärmesenke, Kontaktierungsmaterial, Bonddrähten, Reflektor und gegebenenfalls auch Schutzdiode, Anschlusspad und Dickdrahtbondfuß wird z.B. nach der Montage des Reflektors mit einer Verkapselungsmasse versehen, z.B. einem Epoxy-, Silikon- oder Carbonatkunststoff. Diese Verkapselung schützt die genannten Elemente vor Korrosion.

● Der Reflektor verfügt im oberen Bereich über eine Auskragung, die als Ring ausgebildet ist. Dieser Ring verhindert, dass Strahlung auf die oben genannte Verkapselungsmasse oder die zur Montage des Reflektors verwendeten Klebstoffe fallen kann. Durch die starke Lichtintensität könnte hierdurch die Verkapselungsmasse zerstört werden. Der Erfindungsgegenstand bezieht sich daher auf einen Ring oder eine andere flächige Ausformung, die mindestens so groß ist, dass die darunter befindliche Vergussmasse nicht von der Solarstrahlung getroffen werden kann.

● Dieser Ring ist weiterhin vorteilhaft für die Montage, bei der er als greifbare Fläche für das Pick&Place-Verfahren dient. Hierdurch lässt sich ein Verkratzen der meist empfindlichen Reflektorfläche verhindern. Hierzu ist der Ring in vorteilhafter Weise plan, in vorteilhafter Weise parallel zur Eintrittsapertur ausgeführt. Durch das bevorzugte Verfahren zur Herstellung der Reflektorform, dem Tiefziehen, entsteht dieser Ring ohne weiteren Aufwand und unter minimalem Werkstoffeinsatz.

● Der Ring bzw. eine andere flächige Ausformung am oberen Ende des Reflektors bewirkt eine großflächigere Verteilung der Abwärme im Reflektor. Diese Abwärme entsteht durch eine Absorption der auf den Reflektor treffenden Solarstrahlung bzw. durch die durch Wärmeleitung von der Solarzelle dem Reflektor zugeführte Wärme. Durch die mit dem Ring zur Verfügung gestellte vergrößerte Fläche verbesserte sich der Abtransport der Wärme durch Strahlung bzw. Konvektion der Modul-Innenluft. Die Modul-Innenluft wird wiederum über die Außenwände des Moduls an die Umgebung abgegeben

Betreffend den Herstellungsprozess des Reflektors:

● Verwendung von flachem Bandmaterial der Stärke 50 µm bis 1 mm,

● Ausformung der Reflektorform durch gestuftes Tiefziehverfahren, bei dem mit mehreren Ausstanz- und Umformschritten direkt aus dem flachen Bandmaterial die Reflektorform, der Ring sowie gegebenenfalls besondere Befestigungselemente geformt werden.

● Ein Verfahren, bei dem die einzelnen Reflektorelemente nach den formgebenden Tiefzieh- und Umformprozessen noch nicht vollständig herausgetrennt werden, sondern noch über stegartige Verbindungselemente im Bandstreifen verbleiben. Die so hergestellten Halbzeuge lassen sich gut weiteren Prozessstufen, wie z.B. einer nasschemischen Nachbehandlung zur Oberflächenbehandlung der Reflektorinnenseite, zuführen. Durch die stegartigen Verbindungselemente verbleiben die einzelnen Reflektoren noch in definierter Form und Lage im Streifenverbund und können so optimal weiterprozessiert werden. Insbesondere wird hierdurch ein Ineinanderrutschen der Einzelbauteile verhindert, wodurch die Innenfläche beschädigt und oberflächentechnische Prozesse erschwert bzw. unmöglich gemacht würden. Außerdem wird durch die bestehende Verbindung zwischen allen Reflektoren im Bandmaterial die elektrische Kontaktierung beim Einsatz von elektrochemischen Prozessschritten in der Nachbehandlung erst ermöglicht.

● Anschließend an den ersten formgebenden Tiefzieh- und Umformungsprozess wird das so hergestellte Bandmaterial mit den ausgeformten Reflektoren optional einer nasschemischen Prozessierung unterzogen. Die Prozessschritte betreffen die Reinigung (z.B. tensidische Reinigung, saure Reinigung, alkalische Reinigung), das chemische oder elektrochemische Glänzen, das chemische oder elektrochemische Entgraten sowie das chemische oder elektrochemische Aufbringen einer Oxidschicht.

● Diese Oxidschicht schützt die reflektive Innenfläche vor den Einflüssen der Umgebungsluft.

● Anschließend erfolgt die Vereinzelung der Reflektoren aus dem Streifen durch einen Stanzprozess.

● Nach der nasschemischen Behandlung der Reflektoren kann zur weiteren Erhöhung des Reflektionsgrades das Aufbringen weiterer Schichten, z.B. silber- oder aluminiumhaltiger Spiegelschichten erfolgen. In diesem Fall werden anschließend noch Schutzschichten, z.B. Aluminiumoxid, Siliciumnitrid oder Siliziumdioxid aufgebracht, z.B. durch Sputtern, chemische Dampfphasenabscheidung (CVD) oder nasschemisch. Zur Verhinderung von freiliegenden Materialübergängen kann vor dem Aufbringen dieser Schutzschichten der Reflektor durch Durchtrennen der Stege aus dem Verbund herausgelöst werden. Die Reflektoren durchlaufen dann in einer geeigneten Magaziniervorrichtung die weiteren Prozesse.

● Durch das Tiefziehverfahren können alle aus der Literatur bekannten optimierten Formen, z.B. konische, parabolische, hyperparabolische oder zusammengesetzt parabolische Formen realisiert werden. Durch die erst nach der Umformung aufgebrachten Schutzschichten wird auf diese kein besonderer Stress mehr ausgeübt und die Umformung ist in kritischen Parametern, wie z.B. dem Aspektverhältnis, nur noch durch das Ziehverhalten des Grundmaterials beeinflusst.

Betreffend die Halbleiterbaugruppe mit Reflektor:

● Bevorzugt ist die Halbleiterbaugruppe ein SCA.

● Die Unterseite der Ausgangsapertur des Reflektors ist durch eine erste Klebstoffschicht mit der Solarzellenoberseite verbunden. Dieser Klebstofffilm besitzt jedoch nur eine sehr geringe Kohäsion und/oder Adhäsion. Auf diese Weise wird bei einer thermisch bedingten Ausdehnung des Reflektors keine Kraft auf die Solarzellenoberseite übertragen (Gefahr der Ablösung der Kontaktmetallisierung der Solarzelle). Diese erste Klebstoffschicht stellt also eine Art Sollbruchstelle dar, die beim ersten Ausdehnen des Reflektors im Betriebsfall zerstört wird.

● Daher wird zusätzlich zu dieser ersten Verbindungsschicht eine zweite Klebstoff- bzw. Vergussmasse aufgetragen, die einen Teil des Chipträger sowie einen Teil des Reflektors einschließt. Diese zweite Klebstoffmasse stellt eine mechanisch belastbare, flächige Verbindung zwischen dem Reflektor und dem Chipträger her. Die Kontaktfläche zur Reflektoraußenwand ist dabei deutlich größer im Vergleich zur Fläche der Unterkante des Reflektors. Dadurch kann diese zweite Klebstoffmasse die bei einer thermischen Ausdehnung auftretenden Kräfte deutlich besser aufnehmen. Außerdem kann die im Reflektor durch Absorption entstehende Wärme besser an den Chipträger abgeführt werden.

● Hierzu kann die zweite Klebstoffmasse durch das Füllen mit thermisch gut leitenden Stoffen, z.B. $SiOH$-, $SiO_2$ oder $TiO_2$-Partikeln, oder Keramikpartikeln, in ihrer thermischen Leistungsfähigkeit verbessert werden.

● Diese zweite Vergussmasse kann auch den Rand der Solarzelle sowie die Bonddrähte einschließen. Dadurch wird ein Verkapselungseffekt erzielt und somit werden diese besonders kritischen Bereiche vor Witterungseinflüssen geschützt.

● Die für die zweite Vergussmasse verwendeten Materialien, z.B. thermoplastische Kunststoffe, sind meistens nicht dauerhaft beständig gegen stark konzentrierte Strahlung. Daher ist die Auskragung (z.B. ein Ring bzw. eine ähnliche flächige Ausformung) an der Oberseite des Reflektors von essentieller Bedeutung, um im Betrieb diese Vergussmasse vor einer Beschädigung durch auftreffende Strahlung zu schützen. Bei einem Konzentrator-Modul kann z.B. durch Fehlstellung des Trackers der gesamte Fokus-Strahl auf die Vergussmasse gelenkt werden.

● Alternativ zu diesem Aufbau kann auch der Reflektor über eine Klebeschicht direkt auf die Chipoberfläche, z.B. Oberfläche der Solarzelle, angekoppelt sein. Zur Vermeidung von thermomechanischen Spannungen ist die Klebeschicht aus einem besonders flexiblen Kunststoff ausgeführt und/oder mit Partikeln mit besonders guter Leitfähigkeit, z.B. Silber- oder Kupferpartikeln, gefüllt.

● Als weitere Alternative bietet sich die Verwendung eines Montagebügels an, wie er z.B. aus WO 91/18419 bekannt ist. Aus dieser Anmeldung ist die Verwendung eines Bügels bekannt, die über eine zentrale Aufnahmeöffnung für den eigentlichen Reflektor verfügt. Bevorzugt lässt sich ein derartiger Montagebügel in einem einzigen Verfahrensschritt als monolithischer Verbund mit der Sekundäroptik durch das weiter oben beschriebene kalte Tiefziehverfahren aus einem flachen Metallband direkt aus dem flachen Bandmaterial formen. Diese integrierte Lösung bietet alle Vorteile der Prozessvereinfachung durch den Wegfall von Montageschritten sowie Verringerung des Handlingaufwands durch eine Reduktion der Zahl der benötigten Komponenten. Der Montagebügel übernimmt in diesem Fall die Funktion der abschattenden Auskragung bzw. des Ringes.

● Weiterhin wird ein alternatives Verfahren vorgeschlagen, bei dem der Chipträger über Arretierungsmöglichkeiten (z.B. Laschen) verfügt, die aus der Chipträgerebene herausragen. Die Sekundäroptik verfügt über geeignete Ausformungen, die zur Befestigung auf den Laschen dienen. Die Laschen am Chipträger verfügen über einen Führungsbereich, der zur Aufweitung der entsprechenden Ausformung an der Sekundäroptik dient. Weiterhin verfügen die Arretierungsmöglichkeiten zusätzlich oder alternativ über Überhöhungen (z.B. ausgeformter Dorn oder Kuppe), in die eine entsprechende Aussparung der Ausformung der Sekundäroptik einrasten kann. Die Lasche kann auch an der Sekundäroptik ausgeformt sein, die entsprechende Gegenaufnahme ist dann am Chipträger ausgeformt. Diese Ausgestaltungsform ermöglicht eine zuverlässige, reversible Fixierungsmöglichkeit der Sekundäroptik im gesamten Verbund des Halbleiterbauteils, bei der auf Klebungen weitestgehend verzichtet werden kann.

● Die Solarzelle verfügt auf ihrer Oberseite im Bereich der Auflagefläche des Reflektors über eine geeignete Schicht, um beim Montageprozess eine Beschädigung der Metallisierung oder der darunter liegenden Halbleiterschichten zu verhindern. Diese Schicht kann z.B. als Oxidschicht, Metallschicht oder als Kunststoffschicht, wie Polyimid oder PTFE ausgeführt sein.

● Die Sekundäroptik kann auch zur elektrischen Anbindung der Solarzellenoberseite verwendet werden. Hierzu verfügt der Reflektor über eine vergrößerte Ausformung an der Oberseite, die neben der Solarzelle auf einen zweiten elektrischen Leiterbereich elektrisch leitfähig verbunden wird, wobei der zweite elektrische Leiterbereich vom Chipträger, der den ersten Bereich bildet, elektrisch isoliert ist.

Betreffend das Montageverfahren der Solarzellenbaugruppe:

● Es existieren mehrere vorteilhafte Montageverfahren. Beim erfindungsgemäßen Standard-Montageverfahren wird zunächst eine erste adhäsive Masse mit geringer Viskosität und mit geringer Kohäsion und/oder geringer Adhäsion und/oder sehr hoher Elastizität durch Dispensen, Ink-Jet-Verfahren, Stempeln o.ä. aufgetragen. Anschließend wird die Sekundäroptik mittels eines Greifers, z.B. Vakuumgreifer, aus einer geeigneten Magaziniervorrichtung entnommen und durch ein Vision-System von der Unterseite her vermessen. Unter Berücksichtigung der Korrektur-Information vom Vision-System wird die Sekundäroptik auf die zuvor aufgetragenen erste adhäsive Masse aufgesetzt. Hierzu wird über eine Federspannung eine maximale Aufsetzkraft definiert oder über im Montagekopf eingebaute Abstandshalter oder einen Höhensensor ein definierter Abstand von 10 bis 200 $\mu$m zum Chip eingehalten. Alternativ hierzu kann der Auftrag auch auf den Reflektor erfolgen. Wenn notwendig, kann anschließend diese erste adhäsive Masse vor den weiteren Prozessschritten ausgehärtet werden, bei besonders niedrig viskosen adhäsiven Massen ist dies nicht notwendig. Anschließend wird die so fixierte Sekundäroptik mit einer zweiten adhäsiven Masse teilweise umhüllt. Die erste adhäsive Masse verhindert dabei, dass die zweite adhäsive Masse durch Kapillareffekte auf den aktiven Solarzellenbereich gelangen kann. Abschließend wird die zweite Masse ausgehärtet.

● Ein weiteres vorteilhaftes Montageverfahren hat folgenden Ablauf: Die Baugruppe umfassend Solarzelle, Wärmesenke, Unterseiten- und Oberseitenkontaktierung der Solarzelle sowie evtl. auch der Schutzdiode mit Kontaktierungen sowie evtl. Kontaktpads mit Kontaktierungen, wird mit einer Vergussmasse vergossen. Der Verguss erfolgt dergestalt, dass Teile der Baugruppe oder auch die gesamte Baugruppe in die Vergussmasse eingeschlossen werden. Der vergossene Bereich weist im Bereich der Solarzelle eine Ausnehmung auf, die an die Außenform der Sekundäroptik angepasst ist. In diese Ausnehmung lässt sich der Reflektor einsetzen und durch Reibung oder zusätzlich hinzugefügte Adhäsive dauerhaft fixieren. Diese Ausführungsform weist die Vorteile auf, dass die Solarzelle durch die Verkapselung vor Umwelteinflüssen geschützt werden kann, dass bei einer Wärmeausdehnung des Reflektors die entstehenden Kräfte großflächig in die Vergussmasse eingeleitet werden, sowie dass die durch die absorbierte Strahlung entstehende Wärme über einen großflächigen Kontakt mit der Vergussmasse gut abgeführt werden kann.

● Eine weitere vorteilhafte Ausgestaltung ist die Montage eines Reflektors mittels eines im Voranstehenden beschriebenen Montagebügels. Ebenso bevorzugt ist die Verwendung eines mit Partikeln aus Siliziumoxid, Siliziumhydroxid, Silber o.ä. gut leitenden Materialien enthaltenden Klebstoffes für die Montage des Bügels oder eine Montage mittels direkten Fügens (Schweißen, Löten, Bonden).

● Der Reflektor weist bevorzugt einen Abstand zur Solarzelle auf, der gemessen von der Unterseitenapertur des Reflektors bis zum Oberseitengrid der Solarzelle in Höhe, 20 bis 300 μm beträgt.

● Der Reflektor kann als reflektives Element ausgebildet sein, das aus einem optisch transparenten Bereich mit einem höheren Brechungsindex als Luft, z.B. einem Epoxy-, Silikon- oder Carbonatkunststoff, sowie einer den Seitenbereich umgebenden reflektiven Schicht besteht. Hierdurch ergeben sich zwei wesentliche Vorteile: Erstens ergibt sich durch den höheren Brechungsindex (gegenüber Luft) des optisch transparenten Bereichs eine zusätzliche Ablenkung der von der Primärlinse schräg auf die Oberfläche des transparenten Bereichs eintreffenden Strahlen in Richtung der Solarzelle, zweitens wird die Solarzellenoberfläche durch den transparenten Bereich vor Umwelteinflüssen abgeschirmt. Die Sekundäroptik weist dann zusätzlich zu den reflektiven auch refraktive Eigenschaften auf, die sich auf vorteilhafte Weise ergänzen.

● Ein derartiges Bauelement lässt sich z.B. durch Befüllung eines tiefgezogenen Reflektors mit einer transparenten Masse, z.B. einem Epoxy-, Silikonoder Carbonatkunststoff, realisieren.

● Eine vorteilhafte Ausgestaltung ist die Verwendung von transparenten Massen mit hohem Benetzungswinkel (> 90°) auf Aluminiumoxid. In diesem Fall wird bevorzugt eine konvex-linsenförmige Oberfläche erzeugt, die durch Temperatureffekte im Betrieb noch verstärkt wird. Durch die konvexe Oberfläche werden Randstrahlen vorteilhaft gebrochen und die Zahl der Reflektionen und damit die Verluste minimiert. Die konvexe Ausformung der Oberfläche ist daher vorteilhaft für die Winkelakzeptanz des Konzentrator-Moduls sowie für weitere optische Parameter (Verkippungstoleranz, Konzentrationserhöhung).

● Die Befüllung des Reflektors mit der optisch transparenten Masse kann vor, während oder nach der Montage auf die Solarzelle erfolgen. Eine vorteilhafte Ausführungsform ist die Befüllung des Reflektors vor der Aufbringung auf die Solarzelle. Hierzu wird der Innenraum oder ein Teil des Innenraums des Reflektors ungefähr bis zur Austrittsapertur mit der transparenten Masse gefüllt und diese ausgehärtet. Die Ebene der Austrittsapertur wird von dem transparenten Bereich vorteilhafterweise um 20 bis 300 μm überragt. Hierdurch ergibt sich eine Fläche in der Größe der Ausgangsapertur bzw. des aktiven Bereichs der Solarzelle. Diese Fläche dient zur Montage der Sekundäroptik direkt auf der Solarzelle mittels einer optisch transparenten adhäsiven Masse.

● Eine weitere vorteilhafte Montagemethode ist es, auf die Solarzellebaugruppe vor Montage im Bereich der Solarzelle eine dünnflüssige optisch transparente Masse aufzutragen. In diese Masse wird dann die reflektive Sekundäroptik hineingesetzt und durch Aushärten der Masse fixiert. Der im Inneren der Sekundäroptik befindliche Teil der Vergussmasse dient dabei als Schutzschicht für die aktive Fläche der Solarzelle sowie gleichzeitig durch seine im Vergleich zu Luft höheren Dichte als optische Strahllenkung. Zur Verstärkung dieses Effektes kann durch weiteres Zugießen von transparenter Vergussmasse in den Reflektor eine Verstärkung dieses Effekts erzielt werden. Gleichzeitig dient der außerhalb des Reflektors aushärtende Teil der Vergussmasse als Schutz der Zellränder und der Verbindungen zur Oberflächenkontaktierung (Bonddrähte) vor Witterungseinflüssen.

Der Gegenstand der vorliegenden Erfindung wird anhand der Figuren näher erläutert, ohne diesen auf die in den Figuren speziell dargestellten Parameter zu beschränken.

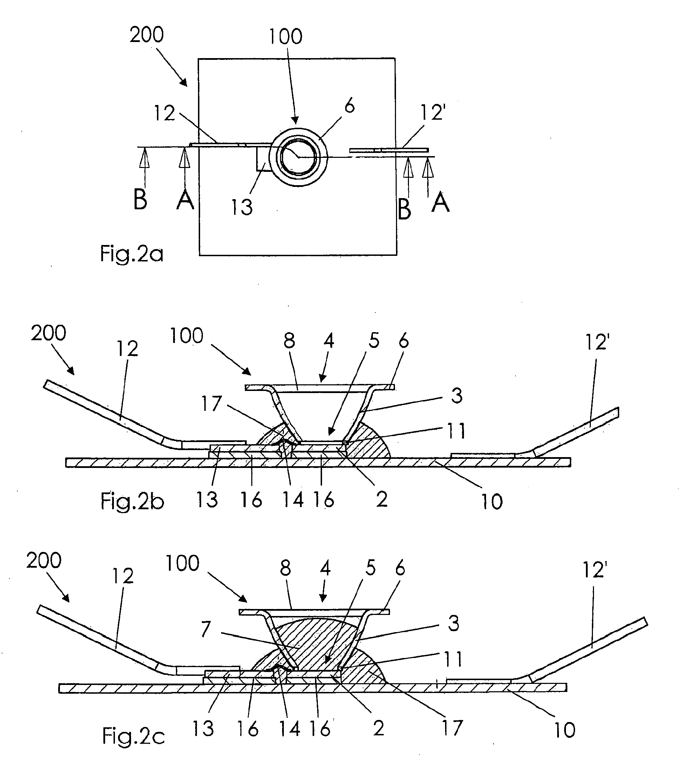

Die Figur 2a zeigt eine spezielle Ausgestaltungsform einer SCA, die eine erfindungsgemäße Sekundäroptik umfasst, in Aufsicht, während die Figuren 2b und 2c Schnitte entlang den in Figur 2a angedeuteten Verbindungslinien A-A bzw. B-B darstellen. Die Figuren 2a, 2b und 2c betreffen dabei eine besondere Ausführungsform, bei der die Sekundäroptik 100 in das Halbleiterbauteil 200, das im vorliegenden Fall eine SCA darstellt, integriert ist, wobei mehrere Klebeverbindungen zur Fixierung des Halbleiterbauteils vorgesehen sind. Alle Bestandteile der SCA 200 sind dabei auf dem Chipträger 10 aufgebracht. Die Solarzelle 2 sowie das Verschaltungspad 13, über die der von der SCA 200 produzierte Strom über die Kontakte zur Verschaltung 12 und 12' abgegriffen werden kann, sind dabei jeweils durch eine Klebung oder Lötung 16 mit dem Chipträger 10 verbunden. Die Stromleitung von der Solarzelle 2 selbst zum Verschaltungspad 13 erfolgt dabei über einen Bonddraht 14. Die erfindungsgemäße Sekundäroptik 100 selbst besteht dabei aus dem als Reflektor 3 ausgebildeten Gehäuse, das im Wesentlichen aus einem metallischen Grundmaterial, das an der Innenseite eine besonders hohe Reflektion für Licht im Wellenlängenbereich von 350 bis 2000 nm aufweist, ausgebildet ist. An der Oberfläche ist eine monolithisch ausgeformte Auskragung 6 ausgebildet, die einerseits als Montagehilfe dienen kann, andererseits gleichzeitig kritische Bereiche der Solarzellenbaugruppe vor dem konzentrierten Sonnenlicht schützt. Dies wird v.a. aus der in Figur 2a dargestellten Aufsicht ersichtlich. Außerdem weist der Reflektor 3 an seiner Außenseite eine Schicht auf, die eine besonders günstige Emissivität im Wellenlängenbereich von 2000 bis 10000 nm aufweist, z.B. eine Schicht aus Aluminiumoxid. Der Chipträger 10 übernimmt dabei die Funktion eines Kühlsubstrates, wobei durch die großflächige Ausbildung des Chipträgers effektiv Wärme abgeleitet werden kann. Eine vorteilhafte Anordnung sieht vor, dass die optische Achse der Sekundäroptik 100 möglichst durch den geometrischen Schwerpunkt der aktiven Fläche der Solarzellenanordnung 200 verläuft. Die Eintrittsapertur 4 der Sekundäroptik 10 ist dabei von einem im interessierenden Wellenlängenbereich transparenten Fenster 8 verschlossen. Die Fixierung der Sekundäroptik 100 mit der Solarzelle 2 erfolgt dabei im Bereich der Austrittsapertur 5 durch eine erste Verklebung 11. Die weitere Verfestigung der Sekundäroptik 100 auf der SCA 200 wird durch eine zusätzliche Verbundmasse 17, die um die Sekundäroptik aufgebracht wird, gewährleistet. Dabei kann die Verbundmasse 17 einige Bestandteile der SCA 200, wie beispielsweise die Solarzelle, das Verschaltungspad 13 und den Bonddraht 14 einschließen. Durch die Auskragung 6 ist gewährleistet, dass zumindest die Verbundmasse sowie die darunter liegenden Teile der SCA 200 von der aggressiven, konzentrierten Sonneneinstrahlung geschützt werden. Dadurch ist sichergestellt, dass das Verbundmaterial 17 effizient vor Alterungsprozessen, wie beispielsweise Versprödung, geschützt ist.

In Figur 2c ist eine alternative Ausführungsform der in den Figuren 2a und 2b dargestellten SCA 200 mit Sekundäroptik 100, dargestellt, wobei hier der Innenraum der Sekundäroptik 100 mit einem optisch transparenten Füllmaterial 7 nahezu gänzlich gefüllt ist. Im Falle, dass dieses Füllmaterial 7 einen hohen Brechungsindex aufweist, erfolgt zusätzlich oder alternativ zur reflektiven Konzentration des Sonnenlichtes innerhalb der Sekundäroptik 100 auch eine refraktive Konzentration. Die Oberfläche des Füllmaterials ist dabei vorzugsweise konvex ausgebildet.

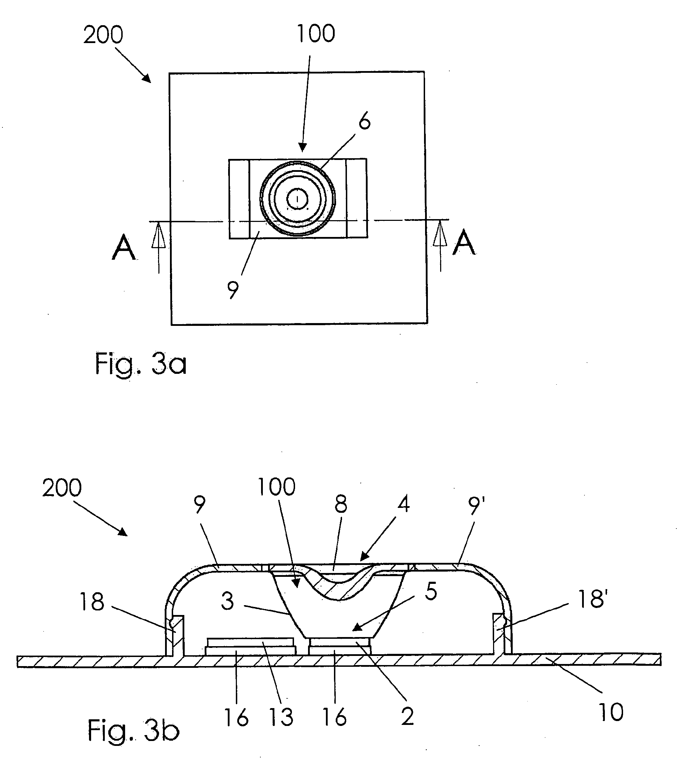

Die Figuren 3a und 3b betreffen eine weitere, vorteilhafte Ausführungsform einer Anordnung 200 mit Sekundäroptik 100, wobei hier nur der Übersichtlichkeit halber einige Bestandteile der SCA 200 (beispielsweise Bonddraht 14) nicht aufgeführt sind. Im Wesentlichen betreffen die Ausführungsformen der Figuren 3a und 3b, wobei Figur 3a eine perspektivische Betrachtungsweise der SCA 200 darstellt, während Figur 3b einen Schnitt entlang der Linie A-A der Figur 3a darstellt, eine alternative Fixierungsmöglichkeit der Sekundäroptik 100 auf dem Chipträger 10. Hierbei weist der Chipträger 10 die Arretierungsmöglichkeiten 18 bzw. 18' auf, die jeweils eine Nut aufweisen, die der Fixierung der mechanischen Befestigungselemente 9 und 9', die jeweils als Bügel ausgeprägt sind, dient. Die Befestigungselemente 9 und 9' sind dabei formschlüssig mit der Sekundäroptik 100 verbunden und übernehmen die Funktion der Auskragung 6. Alternativ hierzu ist es aber auch besonders bevorzugt, wenn die Befestigungselemente 9, 9' monolithisch mit dem Reflektor 3 verbunden sind; dies ist beispielsweise bei einer Herstellung der Sekundäroptik 100 durch ein Tiefziehverfahren möglich. Der besondere Vorteil einer derartigen Ausführungsform ist, dass durch einfache mechanische Mittel eine permanente Fixierung der Sekundäroptik 100 auf der Solarzelle 2 unter Verzicht einer Verklebung hergestellt werden kann. Durch die große Fläche der Bügel 9 und 9', die vorzugsweise aus Metall gebildet sind, ist eine gänzliche Abschirmung der darunter liegenden Bauteile, wie beispielsweise dem Verschaltungspad 13, gewährleistet. Ebenso ist eine gute Ableitung von thermischer Energie über die Bügel 9 und 9' auf den Chipträger 10 ermöglicht.

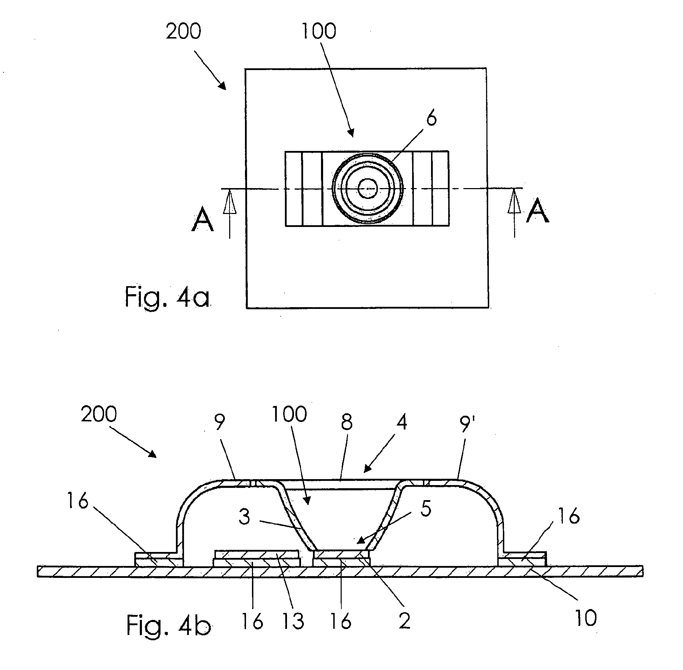

Eine weitere alternative Ausführungsform der mechanischen Fixierung der Sekundäroptik 100 auf dem Chipträger 10 ist in den Figuren 4a und 4b dargestellt, wobei, wie bereits bei den vorangehenden Figuren, die Figur 4b einen Schnitt entlang den Linien A-A der Figur 4a darstellt. Die mechanische Fixierung der Bügelelemente 9 und 9' erfolgt hierbei durch Verklebung 16 mit dem Chipträger 10. Die weiteren Ausführungsformen sind identisch mit den Merkmalen der Figuren 3a und 3b.

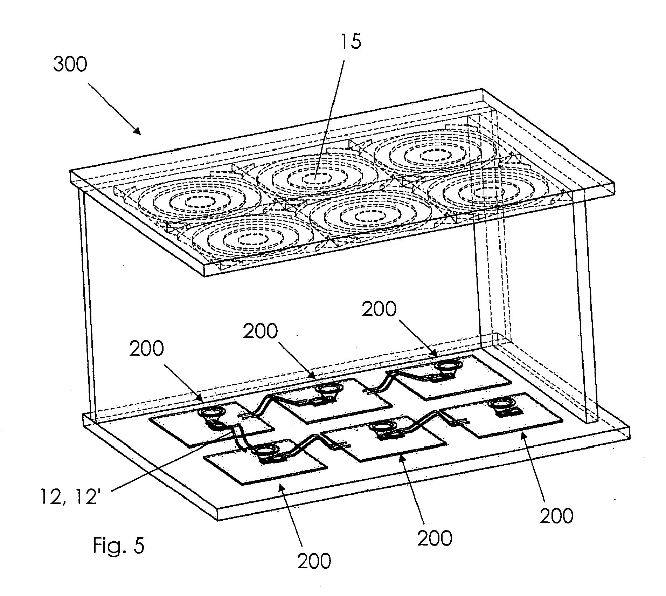

In Figur 5 ist ein Modul 300 dargestellt, das mehrere, über die Kontakte 12 und 12' verschaltete SCAs 200 beinhaltet. Ebenso gezeigt ist die Anordnung der konzentrierenden Primäroptik 15, die in diesem Falle als Fresnel-Kollektor ausgebildet ist.

## Patentansprüche

1. Reflektive und/oder refraktive Sekundäroptik (100) zur Fokussierung von Sonnenlicht auf Halbleiterbauelemente, umfassend einen Reflektor (3) mit einer dem Sonnenlicht zugewandten Eintrittsapertur (4) und einer dem Halbleiterbauteil (2) zugewandten Austrittsapertur (5), wobei der Reflektor (3) eine den Reflektor (3) umschließende Auskragung (6) aufweist.

2. Sekundäroptik nach Anspruch 1,
   **dadurch gekennzeichnet, dass** die Auskragung (6) in Längsrichtung des Reflektors (3) auf Höhe der Eintrittsapertur (4) angeordnet ist.

3. Sekundäroptik nach einem der vorhergehenden Ansprüche,
   **dadurch gekennzeichnet, dass** die Auskragung (6) monolithisch oder formschlüssig mit dem Reflektor (3) verbunden ist.

4. Sekundäroptik nach einem der vorhergehenden Ansprüche,
   **dadurch gekennzeichnet, dass** die Auskragung (6) planparallel zur Eintrittsapertur (4) angeordnet ist.

5. Sekundäroptik nach einem der vorhergehenden Ansprüche,

**dadurch gekennzeichnet, dass** die Auskragung (6) einen Umriss aufweist, der rechteckig, quadratisch, kreisförmig, oval oder unregelmäßig geformt ausgebildet ist.

6. Sekundäroptik nach einem der vorhergehenden Ansprüche,
**dadurch gekennzeichnet, dass** der Reflektor (3) zumindest teilweise aus Materialien, ausgewählt aus der Gruppe bestehend aus Aluminium oder einer Aluminium enthaltenden Legierung besteht.

7. Sekundäroptik nach einem der vorhergehenden Ansprüche,
**dadurch gekennzeichnet, dass** der Reflektor (3) eine Wandungsstärke von 50 $\mu$m bis 1 mm, bevorzugt von 100 bis 500 $\mu$m aufweist.

8. Sekundäroptik nach einem der vorhergehenden Ansprüche,
**dadurch gekennzeichnet, dass** die Außenseite des Reflektors (3) und/oder die der Austrittsapertur (5) zugewandte Oberfläche der Auskragung (6) mindestens eine Beschichtung aufweist, die einen Gesamtemissionsgrad $\varepsilon_n$ zwischen 0,5 und 0,95 im Wellenlängenbereich von 2.000 bis 10.000 nm aufweist.

9. Sekundäroptik nach vorhergehendem Anspruch,
**dadurch gekennzeichnet, dass** die mindestens eine Beschichtung Aluminiumoxid enthält, bevorzugt aus Aluminiumoxid besteht und/oder einen Lack mit einem Gesamtemissionsgrad $\varepsilon_n$ zwischen 0,5 und 0,95 enthält, bevorzugt hieraus besteht.

10. Sekundäroptik nach einem der vorhergehenden Ansprüche,
**dadurch gekennzeichnet, dass** die Innenseite des Reflektors (3) mindestens eine hochreflektive Beschichtung mit einem Reflexionsgrad p > 70 % in einem Wellenlängenbereich von 400 bis 800 nm und/oder einem Reflexionsgrad p > 80 % in einem Wellenlängenbereich von 900 bis 2500 nm und/oder aufweist.

11. Sekundäroptik nach vorhergehendem Anspruch,
**dadurch gekennzeichnet, dass** die hochreflektive Beschichtung ein Metall, ausgewählt aus der Gruppe bestehend aus Aluminium, bevorzugt in hochreiner (> 99 Gew.-%) Form; Silber, Schichtfolge von Materialien mit unterschiedlichen Brechungsindices $n_D^{20}$ und/oder Legierungen oder Kombinationen hieraus enthält oder hieraus besteht.

12. Sekundäroptik nach einem der vorhergehenden Ansprüche,

**dadurch gekennzeichnet, dass** die Innenseite des Reflektors (3) mindestens eine Schutzbeschichtung aufweist, die Aluminiumoxid, Siliciumcarbid und/oder Siliciumoxid enthält oder hieraus besteht.

13. Sekundäroptik nach einem der Ansprüche 10 bis 12,
**dadurch gekennzeichnet, dass** auf der Innenseite des Reflektors (3) mindestens eine hochreflektive Beschichtung und auf der mindestens einen hochreflektiven Beschichtung mindestens eine Schutzbeschichtung aufgebracht ist.

14. Sekundäroptik nach einem der vorhergehenden Ansprüche,
**dadurch gekennzeichnet, dass** der Hohlraum zumindest teilweise mit einem im Wellenlängenbereich von 300 bis 2.500 nm optisch transparenten Material (7) gefüllt ist.

15. Sekundäroptik nach einem der beiden vorhergehenden Ansprüche,
**dadurch gekennzeichnet, dass** das optisch transparente Material (7) einen höheren Brechungsindex $n_D^{20}$ als Luft besitzt.

16. Sekundäroptik nach einem der Ansprüche 14 bis 15,
**dadurch gekennzeichnet, dass** das optisch transparente Material (7) in flüssigem Aggregatszustand einen Benetzungswinkel von mehr als 90 ° auf Aluminiumoxid aufweist.

17. Sekundäroptik nach einem der Ansprüche 14 bis 16,
**dadurch gekennzeichnet, dass** das optisch transparente Material (7) ausgewählt ist aus der Gruppe bestehend aus Epoxidharz, Siliconharz, Polycarbonat, Polyacrylaten, Glas, Quarzglas und/oder thermoplastische Kunststoffen.

18. Sekundäroptik nach einem der vorhergehenden Ansprüche,
**dadurch gekennzeichnet, dass** die Eintritts- und/oder die Austrittsapertur (5) mit einem im Wellenlängenbereich von 300 bis 2.500 nm optisch transparenten Fenster (8) verschlossen ist.

19. Sekundäroptik nach einem der beiden vorhergehenden Ansprüche,
**dadurch gekennzeichnet, dass** das optisch transparente Fenster (8) ausgewählt ist aus der Gruppe bestehend aus Glas, Plexiglas, Siliciumoxid, Siliciumcarbid und/oder Aluminiumoxid.

20. Sekundäroptik nach einem der vorhergehenden Ansprüche,
**dadurch gekennzeichnet, dass** sich an die Auskragung (6) zumindest einseitig ein formschlüssig angeformtes Befestigungselement (9) anschließt, über den die Sekundäroptik mit einem Halbleiterelement und/oder einem Chipträger (10) verbindbar ist.

21. Sekundäroptik nach vorhergehendem Anspruch, **dadurch gekennzeichnet, dass** sich an zumindest zwei gegenüberliegenden Seiten der Auskragung (6) je ein Befestigungselement (9) anschließt.

22. Sekundäroptik nach einem der beiden vorhergehenden Ansprüche, **dadurch gekennzeichnet, dass** das mindestens eine Befestigungselement (9) monolithisch an die Auskragung (6) angeformt ist.

23. Licht absorbierende und/oder Licht emittierende Halbleiterbaugruppe, umfassend eine Sekundäroptik nach einem der Ansprüche 1 bis 22 sowie ein Licht absorbierendes und/oder Licht emittierendes Halbleiterbauteil (2), **dadurch gekennzeichnet, dass** die Sekundäroptik (100) über ihre Austrittsapertur (5) formschlüssig mit dem Licht absorbierenden und/oder Licht emittierenden Halbleiterbauteil (2) verbunden ist.

24. Halbleiterbaugruppe nach vorhergehendem Anspruch, **dadurch gekennzeichnet, dass** der Verbund durch Verklebung (11) und/oder mechanische Fixierung (9) realisiert wird.

25. Halbleiterbaugruppe nach vorhergehendem Anspruch, **dadurch gekennzeichnet, dass** die Verklebung (11) geringe Kohäsion und/oder Adhäsion aufweist.

26. Halbleiterbaugruppe nach einem der Ansprüche 23 bis 25, **dadurch gekennzeichnet, dass** die Sekundäroptik (100) vom Licht absorbierenden und/oder Licht emittierenden Halbleiterbauteil (2) in einem Abstand von 1 bis 5000 µm, bevorzugt von 5 bis 1000 µm, besonders bevorzugt zwischen 10 und 300 µm angeordnet ist, wobei zumindest der zwischen der Sekundäroptik (100) und dem Licht absorbierenden und/oder Licht emittierenden Halbleiterbauteil (2) mit der Verklebung (11) gefüllt ist.

27. Halbleiterbaugruppe nach einem der Ansprüche 23 bis 26, **dadurch gekennzeichnet, dass** mindestens eine weiteres Bauteil, ausgewählt aus der Gruppe bestehend aus Kontakten (12, 12') zur elektrischen Verschaltung der Halbleiterbaugruppe mit mindestens einer weiteren Halbleiterbaugruppe, einem Chipträger (10), einem Verschaltungspad (13), einem Bonddraht (14) zur elektrischen Verschaltung des Licht absorbierenden und/oder Licht emittierenden Halbleiterbauteils (2) mit dem Verschaltungspad (13), mindestens eine Schutzdiode und/oder mindestens einer Primäroptik (15) zur Konzentration von Licht auf die Sekundäroptik (100), wie z.B. ein Fresnel-Kollektor, Linse und/oder Spiegel umfasst ist.

28. Halbleiterbaugruppe nach vorhergehendem Anspruch, **dadurch gekennzeichnet, dass** das Licht absorbierende und/oder Licht emittierende Halbleiterbauteil (2) und/oder das Verschaltungspad (13) auf dem Chipträger (10) fixiert sind, bevorzugt durch Klebung (16).

29. Halbleiterbaugruppe nach einem der beiden vorhergehenden Ansprüche, **dadurch gekennzeichnet, dass** das Licht absorbierende und/oder Licht emittierende Halbleiterbauteil (2) und die Sekundäroptik (100) mit einer Verbundmasse (17) auf dem Chipträger (10) fixiert sind, wobei die Verbundmasse (17) zumindest das Licht absorbierende und/oder Licht emittierende Halbleiterbauteil (2) und die Sekundäroptik (100) zumindest teilweise einschließt.

30. Halbleiterbaugruppe nach vorhergehendem Anspruch, **dadurch gekennzeichnet, dass** die Verbundmasse (17) ausgewählt ist aus der Gruppe bestehend aus thermoplastischen Kunststoffen, Epoxidharzen, Siliconen, Acrylaten und/oder Cyanacrylaten.

31. Halbleiterbaugruppe nach einem der beiden vorhergehenden Ansprüche, **dadurch gekennzeichnet, dass** die Verbundmasse (17) thermisch leitende Materialien, wie z.B. Metallspäne oder Metallpartikel, bevorzugt Silberpartikel, Kupferpartikel und/oder Keramikpartikel, Kieselgel und/oder Kombinationen hieraus enthält.

32. Halbleiterbaugruppe nach einem der Ansprüche 29 bis 31, **dadurch gekennzeichnet, dass** in Projektionsrichtung auf den Chipträger (10) die Verbundmasse (17) vollständig von der Auskragung (6) der Sekundäroptik (100) verdeckt ist.

33. Halbleiterbaugruppe nach einem der Ansprüche 23 bis 32, **dadurch gekennzeichnet, dass** die Sekundäroptik (100) über das mindestens eine Befestigungselement (9) mit dem Licht absorbierenden und/oder Licht emittierenden Halbleiterbauteil (2) und/oder dem Chipträger (10) verbunden ist.

34. Halbleiterbaugruppe nach einem der Ansprüche 23 bis 33, **dadurch gekennzeichnet, dass** der Chipträger (10) mindestens eine formschlüssige, reversible Arretierung (18) aufweist, mit der das mindestens eine Befestigungselement (9) verbindbar ist.

35.  Halbleiterbaugruppe nach einem der Ansprüche 23 bis 34,
**dadurch gekennzeichnet, dass** das mindestens eine Licht absorbierende und/oder Licht emittierende Halbleiterbauteil (2) zumindest auf der mit der Sekundäroptik (100) verbundenen Seite zumindest eine Schutzbeschichtung, vorzugsweise ausgewählt aus der Gruppe bestehend aus einer Metallschicht; Oxidschicht, insbesondere Aluminiumoxid und/oder Kunststoffschicht, wie z.B. Polyimid und/oder PTFE, aufweist.

36.  Halbleiterbaugruppe nach einem der Ansprüche 23 bis 35,
**dadurch gekennzeichnet, dass** die Sekundäroptik (100) elektrisch mit dem mindestens einen Licht absorbierenden und/oder Licht emittierenden Halbleiterbauteil (2) kontaktiert ist.

37.  Halbleiterbaugruppe nach einem der Ansprüche 23 bis 36,
**dadurch gekennzeichnet, dass** die Halbleiterbaugruppe mit mindestens einer weiteren Halbleiterbaugruppe über den mindestens einen Kontakt elektrisch seriell und/oder parallel verschaltet ist.

38.  Verfahren zur Herstellung einer Halbleiterbaugruppe nach einem der Ansprüche 23 bis 37,
**dadurch gekennzeichnet, dass** eine Sekundäroptik nach einem der Ansprüche 1 bis 22 auf einem Licht absorbierenden und/oder Licht emittierenden Halbleiterbauteil (2) und/oder auf einem Chipträger (10) fixiert wird.

39.  Verfahren nach vorhergehendem Anspruch, umfassend die folgenden Schritte:

a) Auftragen einer Verklebung (11) auf dem Licht absorbierenden und/oder Licht emittierenden Halbleiterbauteil (2)
b) Aufdrücken der Sekundäroptik (100) auf dem Licht absorbierenden und/oder Licht emittierenden Halbleiterbauteil (2), so dass ein Abstand zwischen von 1 bis 5000 µm, bevorzugt von 5 bis 1000 µm, besonders bevorzugt von 10 bis 300 µm zwischen Sekundäroptik (100) und dem Licht absorbierenden und/oder Licht emittierenden Halbleiterbauteil (2) eingehalten wird,
c) Umhüllen des im Schritt a) und b) hergestellten Verbundes mit einer Verbundmasse (17), die im Anschluss ausgehärtet wird.

40.  Verfahren nach vorhergehendem Anspruch,
**dadurch gekennzeichnet, dass** das Auftragen der Verklebung (11) mittels Ink-Jet-Verfahren und/oder Stempelprozessen erfolgt.

41.  Verfahren nach Anspruch 38,
**dadurch gekennzeichnet**, umfassend die folgenden Schritte:

a) Auftragen einer Verbundmasse (17) um das Licht absorbierende und/oder Licht emittierende Halbleiterbauteil (2) unter Freilassung einer Ausnehmung,
b) Einsetzen und Fixieren der Sekundäroptik (100) in die Ausnehmung.

42.  Verfahren nach vorhergehendem Anspruch,
**dadurch gekennzeichnet, dass** die Vergussmasse auf den Chipträger (10), auf dem das Licht absorbierende und/oder Licht emittierende Halbleiterbauteil (2) angeordnet ist, aufgetragen wird.

43.  Verfahren nach vorhergehendem Anspruch,
**dadurch gekennzeichnet, dass** weiterhin der Bonddraht (14), das Verschaltungspad (13) und/oder die mindestens eine Schutzdiode zumindest teilweise von der Vergussmasse eingeschlossen werden.

44.  Verfahren nach einem der Ansprüche 41 bis 43,
**dadurch gekennzeichnet, dass** das Fixieren der Sekundäroptik (100) durch Haftreibung und/oder Zugabe weiterer Adhäsive auf die Kontaktflächen zwischen der Sekundäroptik (100) und der Ausnehmung der Vergussmasse erfolgt.

45.  Verfahren nach einem der Ansprüche 38 bis 44,
**dadurch gekennzeichnet, dass** die Sekundäroptik (100) zumindest mittels des mindestens einen Befestigungselementes (9) auf dem Chipträger (10) fixiert wird.

46.  Verfahren nach vorhergehendem Anspruch,
**dadurch gekennzeichnet, dass** die Fixierung derart erfolgt, dass das mindestens eine Befestigungselement (9) mit dem Chipträger (10) verklebt, verschraubt, vernietet, verschweißt, verlötet und/oder gebonded wird und/oder über Arretierungsmöglichkeiten (18), wie z.B. ein ausgeformter Dorn oder eine Kuppe direkt fixiert wird.

47.  Verfahren nach Anspruch 38,
**dadurch gekennzeichnet, dass** auf das Licht absorbierende und/oder Licht emittierende Halbleiterbauteil (2) eine Verklebung (11) aufgetragen wird, die Sekundäroptik (100) auf die mit der Verklebung (11) beschichtete Stelle des Licht absorbierenden und/oder Licht emittierenden Halbleiterbauteils (2) aufgedrückt wird und im Anschluss das Adhäsionsmittel ausgehärtet wird.

Fig.1a

Fig.1b

200  100

12  6  12'

B  A  B  A

13

Fig.2a

200  100  8  4  5  6

12  12'

17  3

11

Fig.2b  13  16  14 16  2  10

200  100  8  4  5  6

12  12'

7  3

11

13  16  14 16  2  17  10

Fig.2c

Fig. 3a

Fig. 3b

200    100

6

A    A

Fig. 4a

200    9    100    8    4    9'

16    16

3    5

16    16    16    2    10

Fig. 4b    16  13  16

Fig. 5

**Europäisches Patentamt**

**EUROPÄISCHER RECHERCHENBERICHT**

Nummer der Anmeldung

EP 07 02 4799

### EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| X | WO 2005/043627 A (CREE INC [US]; ANDREWS PETER S [US]; LOH BAN P [US]) 12. Mai 2005 (2005-05-12) | 1-6,11, 14,15, 18-24, 26-28, 33,34,38 | INV. H01L31/052 H01L33/00 H01L25/04 |
| | * Absätze [0046] - [0055], [0058]; Abbildungen 1-6 *<br>----- | | |
| X | JP 2005 175389 A (CITIZEN ELECTRONICS) 30. Juni 2005 (2005-06-30) | 1-5,7, 10,11, 14,15, 17,20, 21,23, 24, 26-28, 33,38, 45-47 | |
| A | * Absätze [0013] - [0019], [0022], [0023]; Abbildungen 1-5 *<br>----- | 39 | |
| X | US 2006/102917 A1 (OYAMA TOSHIHIKO [JP] ET AL) 18. Mai 2006 (2006-05-18) | 1-6,14, 15, 17-19,22 | **RECHERCHIERTE SACHGEBIETE (IPC)** |
| A | * Absätze [0059] - [0063], [0066], [0067], [0069] - [0076]; Abbildungen 1-6,9-12 *<br>----- | 23,24, 27-30, 33,36, 38, 41-43, 45,46 | H01L F24J G02B |
| A | JP 2007 066828 A (HITOKI JAPAN KK) 15. März 2007 (2007-03-15) | 1-4,10, 11,18, 20,21, 23,24, 33,38 | |
| | * Absätze [0033] - [0035]; Abbildungen 1-4 *<br>-----<br>-/-- | | |

Der vorliegende Recherchenbericht wurde für alle Patentansprüche erstellt

| Recherchenort | Abschlußdatum der Recherche | Prüfer |
|---|---|---|
| Berlin | 26. Juni 2008 | Segerberg, Tomas |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus anderen Gründen angeführtes Dokument

................................................................
& : Mitglied der gleichen Patentfamilie, übereinstimmendes Dokument

EPO FORM 1503 03.82 (P04C03)

**Europäisches Patentamt**

## EUROPÄISCHER RECHERCHENBERICHT

**Nummer der Anmeldung**

EP 07 02 4799

### EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| D,A | US 5 118 361 A (FRAAS LEWIS M [US] ET AL) 2. Juni 1992 (1992-06-02) <br> * Spalte 2, Zeile 46 - Spalte 3, Zeile 15 * <br> * Spalte 7, Zeilen 24-33 * <br> * Spalte 7, Zeile 64 - Spalte 8, Zeile 41; Abbildungen 1-3,7 * <br> ----- | 1,20,21, 27,33,38 | |

RECHERCHIERTE SACHGEBIETE (IPC)

Der vorliegende Recherchenbericht wurde für alle Patentansprüche erstellt

| Recherchenort | Abschlußdatum der Recherche | Prüfer |
|---|---|---|
| Berlin | 26. Juni 2008 | Segerberg, Tomas |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus anderen Gründen angeführtes Dokument

.........................................................................

& : Mitglied der gleichen Patentfamilie, übereinstimmendes Dokument

EPO FORM 1503 03.82 (P04C03)

**ANHANG ZUM EUROPÄISCHEN RECHERCHENBERICHT
ÜBER DIE EUROPÄISCHE PATENTANMELDUNG NR.**

EP 07 02 4799

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

26-06-2008

| Im Recherchenbericht angeführtes Patentdokument | Datum der Veröffentlichung | Mitglied(er) der Patentfamilie | Datum der Veröffentlichung |
|---|---|---|---|
| WO 2005043627 A | 12-05-2005 | CA 2549822 A1<br>CN 1871710 A<br>EP 1680816 A1<br>JP 2007509505 T<br>KR 20070090071 A | 12-05-2005<br>29-11-2006<br>19-07-2006<br>12-04-2007<br>05-09-2007 |
| JP 2005175389 A | 30-06-2005 | KEINE | |
| US 2006102917 A1 | 18-05-2006 | CN 1672269 A<br>WO 2004001862 A1<br>JP 3912607 B2 | 21-09-2005<br>31-12-2003<br>09-05-2007 |
| JP 2007066828 A | 15-03-2007 | KEINE | |
| US 5118361 A | 02-06-1992 | WO 9118419 A1 | 28-11-1991 |

EPO FORM P0461

Für nähere Einzelheiten zu diesem Anhang : siehe Amtsblatt des Europäischen Patentamts, Nr.12/82

## IN DER BESCHREIBUNG AUFGEFÜHRTE DOKUMENTE

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

### In der Beschreibung aufgeführte Patentdokumente

- US 5505789 A
- ES 2232299
- EP 0657948 A2
- WO 9118419 A
- US 5167724 A
- WO 2004077558 A1
- DE 19536454 A1
- DE 19947044 B4
- WO 2006130520 A2

### In der Beschreibung aufgeführte Nicht-Patentliteratur

- **V. Diaz ; J. Alarez ; J. Alonso et al.** Assembly of Concentrator Modules based on Silicon Solar Cells at 300x of Concentrated Sunlight. *Proc. of 19th European Photovoltaic Solar Energy Conference,* 2004
- **L. M. Fraas.** *Line-Fokus Photovoltaic Module Using Stacked Tandem-Cells,* 1994
- **J. Jaus ; U. Fleischfresser ; G. Peharz et al.** Heat Sink Substrates for Automated Assembly of Concentrator Modules. *Proc. of 21st European Photovoltaic Solar Energy Conference,* 2006, 2120-2123
- **A. W. Bett ; C. Baur ; F. Dimroth et al.** FLATCON™-modules: Technology and Characterisation. *Proc. of 3rd World Conference on Photovoltaic Energy Conversion,* 2003, 634-637